# EUROPEAN PATENT APPLICATION

(11) **EP 3 223 297 A1**
(43) Date of publication of application: **27.09.2017**
(21) Application number: 17161381.3
(22) Date of filing: 16.03.2017
(51) Int. Cl.: H01J 37/02, H01J 37/30, H01J 37/28

(54) **DUAL-BEAM CHARGED PARTICLE APPARATUS WITH ANTI-CONTAMINATION SHIELD**

(30) Priority: 18.03.2016 JP 2016055758
(71) Applicant: Hitachi High-Tech Science Corporation, Tokyo (JP)
(72) Inventor: OONISHI, Tsuyoshi, Tokyo (JP); HASUDA, Masakatsu, Tokyo (JP)
(74) Representative: Cabinet Chaillot

(57) **Abstract**

Disclosed herein is a composite charged particle beam apparatus including a sample tray 15 on which a sample S is placed; a focused ion beam column 11 irradiating the sample by using a focused ion beam; an electron beam column 12 irradiating the sample by using an electron beam; a sample chamber receiving the sample tray, and the columns therein; an anti-contamination plate 22 moving between an inserted position inserted into a space between a beam emission surface 12a of the electron beam column and the sample tray, thus preventing the electron beam column from being contaminated by sputtered particles M, and an open position withdrawn from the space between the beam emission surface and the sample tray; and an operation unit operating the anti-contamination plate to move between the positions.

## Description

### BACKGROUND OF THE INVENTION

### 1. Technical Field

The present invention relates generally to a composite charged particle beam apparatus capable of obtaining a cross-section image of a sample by irradiating a cross section, which is obtained by a focused ion beam, of the sample with an electron beam.

### 2. Description of the Related Art

For example, as a method of analyzing or observing an internal structure of a sample such as a semiconductor device, etc. or performing a three-dimensional observation thereof, a method of obtaining a cross-section image of a sample (for example, Patent Document 1) is well known. The method includes: performing cross section processing (etching processing) by using a focused ion beam (FIB) column; and obtaining cross-section image by emitting an electron beam (EB) by using scanning electron microscopy (SEM).

The method for cross section processing and observation is a method called "Cut& See" using a composite charged particle beam apparatus. It is possible to use the method to observe a cross-section image while performing cross section processing on a sample, something impossible using other methods.

### Document of Related Art

(Patent Document 1) Japanese Patent Application Publication No. 2008-270073

### SUMMARY OF THE INVENTION

However, the composite charged particle beam apparatus used for the method for cross section processing and observation has a problem that an electron beam column may be easily contaminated by sputtered particles that are scattered from a sample when a focused ion beam is projected thereon. That is, the composite charged particle beam apparatus provides the electron beam column close to a sample tray on which a sample is placed in order to reduce attenuation of the performance of the emitted electron beam. Thus, sputtered particles that are scattered from the sample when the focused ion beam is projected thereon easily adhere to an objective lens, etc. of an electron beam column. In addition, the sputtered particles may cause an increase in costs, and bending of the track of the electron beam or changing in a focus or an emitting point. Also, insulating properties between electrodes may be reduced.

Accordingly, the present invention has been made keeping in mind the above problems occurring in the related art, and an object of the present invention is to provide a composite charged particle beam apparatus including a focused ion beam column and an electron beam column, the apparatus preventing the electron beam column from being contaminated so as to emit an electron beam with high precision.

In order to accomplish the above object, the present invention provides a composite charged particle beam apparatus.

That is, the composite charged particle beam apparatus includes: a sample tray on which a sample is placed; a focused ion beam column irradiating a focused ion beam on the sample; an electron beam column irradiating an electron beam on the sample; a sample chamber accommodating the sample tray, the focused ion beam column, and the electron beam column; an anti-contamination plate displaceable between an inserted position inserted between a beam emission surface of the electron beam column and the sample tray and an open position taken out from between the beam emission surface and the sample tray; and an operation unit for displacing the anti-contamination plate between the inserted position and the open position.

According to the composite charged particle beam apparatus, when emitting the focused ion beam from the focused ion beam column, the anti-contamination plate is positioned at the inserted position, whereby the front of the beam emission surface of the electron beam column is shielded by the anti-contamination plate. When the sample is irradiated by using the focused ion beam, sputtered particles are scattered from the sample. Lots of sputtered particles are scattered toward the electron beam column that is positioned close to the sample. However, the front of the beam emission surface of the electron beam column is shielded by the anti-contamination plate. Therefore, sputtered particles do not enter the electron beam column from the beam emission surface thereof and, for example, do not adhere to an objective lens, etc. Thus, it is possible to prevent the inside of the electron beam column 12 from being contaminated by the scattered sputtered particles.

The anti-contamination plate may cover the beam emission surface of the electron beam column and vicinities thereof at the inserted position.

The operation unit may be provided outside of the sample chamber.

The anti-contamination plate may be made of a non-magnetic material.

The anti-contamination plate may be made of a band-shaped 1 spring material.

The anti-contamination plate may be supported by a supporting member such that the anti-contamination plate may be supported to be slidable along a longitudinal direction by a supporting member supporting both side surfaces of the anti-contamination plate along a longitudinal direction and vicinities thereof and the supporting member is placed at a position not overlapping with the beam emission surface of the electron beam column.

The anti-contamination plate may have a cross section provided in an arc shape perpendicular to a length direction of the anti-contamination plate, and may have ends of both sides that protrude towards beam emission surface of the electron beam column more than a center portion.

According to the present invention, the composite charged particle beam apparatus includes the focused ion beam column and the electron beam column, and prevents the electron beam column from being contaminated, whereby it is possible to emit an electron beam with high precision.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a schematic configuration view showing a composite charged particle beam apparatus according to an embodiment of the present invention;
FIG. 2 is a main portion enlarged perspective view showing an anti-contamination plate and a supporting member of a column contamination prevention unit;
FIG. 3 is a main portion enlarged perspective view showing a supporting member when viewed from the rear;
FIG. 4 is a cross-sectional view showing the anti-contamination plate and the supporting member when viewed from a vicinity of an electron beam column;
FIG. 5 is a cross-section view showing an anti-contamination plate and a supporting member when viewed from a vicinity of an electron beam column according to another embodiment of the present invention;
FIG. 6 is a main portion schematic view showing a state of an anti-contamination plate at an inserted position; and
FIG. 7 is a main portion schematic view showing a stage of the anti-contamination plate at an open position.

### DESCRIPTION OF THE PREFERRED EMBODIMENTS

Hereinafter, a composite charged particle beam apparatus according to embodiments of the present invention will be described in detail below with reference to the accompanying drawings. Repeated descriptions and descriptions of known functions and configurations which have been deemed to make the gist of the present invention unnecessarily obscure will be omitted below. The embodiments of the present invention are intended to fully describe the present invention to a person having ordinary knowledge in the art to which the present invention pertains. Accordingly, the shapes, sizes, etc. of components in the drawings may be exaggerated to make the description clearer.

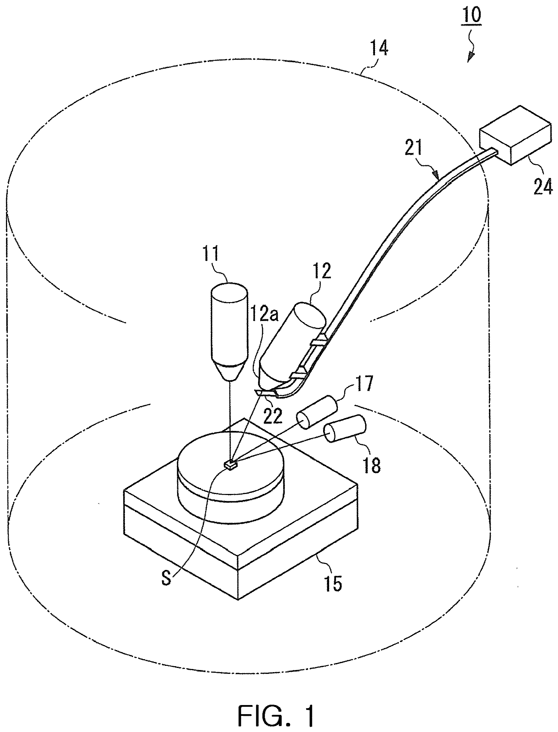

FIG. 1 is a schematic configuration view showing a composite charged particle beam apparatus according to an embodiment of the present invention.

According to the embodiment of the present invention, an FIB-SEM apparatus (composite charged particle beam apparatus) 10 includes a focused ion beam (FIB) column 11, an electron beam (EB) column 12, a sample tray 15 having a turn table on which a sample S is placed, and a sample chamber 14 accommodating the aforementioned elements therein.

The focused ion beam column 11 and the electron beam column 12 are fixed in the sample chamber 14. In addition, the focused ion beam column 11 and the electron beam column 12 are provided to emit respective beams perpendicular to each other on the sample S, whereby it is possible to irradiate a processed cross section by using an electron beam perpendicular thereto, and to obtain a high resolution cross-section image.

The FIB-SEM apparatus 10 further includes a secondary electron detector 17 and an EDS detector 18. The secondary electron detector 17 irradiates a sample S by using a focused ion beam or an electron beam, and detects secondary electrons generated from the sample S. In addition, the EDS detector 18 irradiates a sample S by using an electron beam, and detects X-rays generated from the sample S. The X-rays generated from the sample S includes characteristic X-rays for each substance of a sample S, and a substance of a sample S may be specified by the characteristic X-rays.

In addition, instead of the secondary electron detector 17, it is desirable to use a back-scattered electron detector. The back-scattered electron detector detects back-scattered electrons that are back-scattered by an electron beam from a sample S. By using the back-scattered electrons, it is possible to obtain a cross-section image

In addition, the secondary electron detector 17 or the back-scattered electron detector is provided in the electron beam column so as to be used as an SEM column.

In addition, instead of the EDS detector 18, it is desirable to use an EBSD detector. In the EBSD detector, when a crystalline material is irradiated by an electron beam, a diffraction figure, namely, an EBSD pattern is observed by back-scattering diffraction of an electron ray that occurs at a surface of a sample S, and information of a system of crystallization and crystal orientation of the sample S is obtained. By measuring and analyzing the EBSD pattern, distribution of a crystal orientation in a micro region of the sample S may be specified.

The sample chamber 14 is, for example, a pressure resistant housing having an airtight structure where internal pressure may be reduced. In the sample chamber 14, a vacuum pump (not shown) is provided to reduce internal pressure.

In a vicinity of a beam emission surface (aperture) of the electron beam column 12 emitting an electron beam, a column contamination prevention unit 21 is provided. The column contamination prevention unit 21 includes: an anti-contamination plate 22; a supporting member 23 supporting the anti-contamination plate 22 in a slidable manner; and an operation unit 24 moving the anti-contamination plate 22.

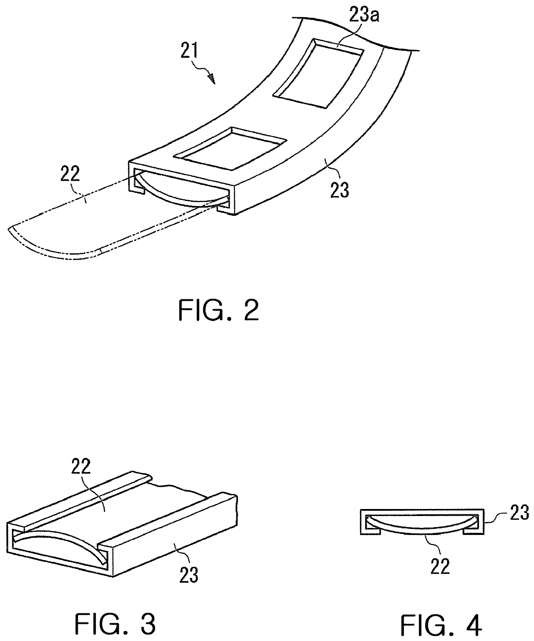

FIG. 2 is a main portion enlarged perspective view showing an anti-contamination plate and a supporting member of a column contamination prevention unit. FIG. 3 is a main portion enlarged perspective view showing a supporting member when viewed from the rear. FIG. 4 is a cross-sectional view showing the anti-contamination plate and the supporting member when viewed from a vicinity of an electron beam column.

The anti-contamination plate 22 is made of a non-magnetic material, and is made of a thin and long leaf spring having a string shape and a high elastic limit. A thin plate of non-magnetic steel, a thin plate of phosphor bronze, a thin plate of a resin, etc. may be used as a leaf spring. According to the embodiment of the present invention, a leaf spring made of a thin plate of phosphor bronze is used as an anti-contamination plate 22. The anti-contamination plate 22 has, for example, a cross section provided in an arc shape perpendicular to a length direction of the anti-contamination plate. By using the leaf spring provided in an arc shape, the anti-contamination plate 22 may extend up to a predetermined length in a straight line without being bent in spite of being not supported.

The supporting member 23 is a hollow strip shape member supporting both opposite-side surfaces of the anti-contamination plate 22 and vicinities thereof along a length direction such that the anti-contamination plate 22 is slidable in the length direction. In addition, a front end of the supporting member 23 has a linear shape in order to determine a direction when the anti-contamination plate 22 extends. It is desirable to provide a plurality of openings 23a to the supporting member 23 in order to lighten the supporting member and to shorten vacuum exhaust time. The supporting member 23 is, for example, made of resin materials or non-magnetic metallic materials, etc.

The supporting member 23 has a first end placed with the electron beam column 12, and extends to the outside of the sample chamber 14 along the electron beam column 12, and has a second end reaching the operation unit 24. The anti-contamination plate 22 has a first end extending to a vicinity of the electron beam column 12 by being supported by the supporting member 23, and has a second end connected to the operation unit 24. In addition, the supporting member 23 is provided at a position that does not overlap with a beam emission surface 12a of the electron beam column 12, and does not interfere when an electron beam is emitted. That is, a first end of the supporting member 23 extends to a vicinity of the electron beam column 12, but the first end is not positioned in a position that overlaps with the beam emission surface 12a of the electron beam column 12.

In addition, instead of that a second end of the anti-contamination plate 22 is directly connected to the operation unit 24, for example, it is desirable to place the anti-contamination plate 22 in a vicinity of the electron beam column 12, and to connect a second end of the anti-contamination plate 22 to the operation unit 24 through a connection member such as a tube wire, etc. In this case, the anti-contamination plate 22 or the supporting member 23 may be placed in only a vicinity of the electron beam column 12, and a second end of the supporting member 23 and the operation unit 24 may be connected to each other via the connection member such as a tube wire, etc.

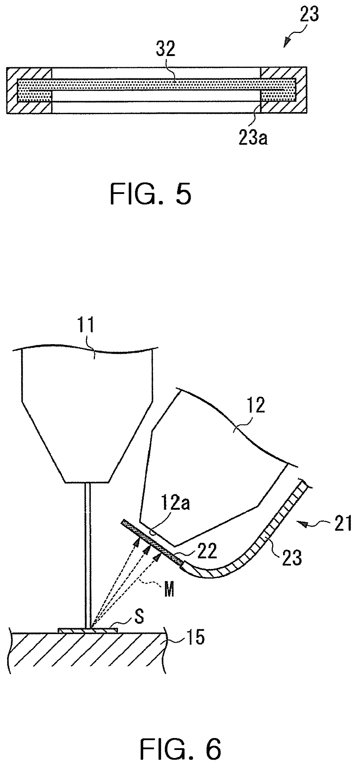

In addition, instead of using the leaf spring having an arch shape cross section as an anti-contamination plate, for example, it is possible to use an anti-contamination plate 32 having opposite-side surfaces folded back as shown in FIG. 5. With the anti-contamination plate 32, the opposite-side surfaces are thick. Therefore, similar to the anti-contamination plate 22 having an arch-shape cross section (referring to FIG. 4), the anti-contamination plate 32 may extend up to a predetermined length in a straight line without having a front end drooping due to its own weight and without being supported by the supporting member 23.

The operation unit 24 is, for example, composed of a member such as a solenoid, etc. capable of linearly moving the anti-contamination plate 22. The operation unit 24 is controlled manually, or is controlled by a control device (not shown) controlling the entire composite charged particle beam apparatus 10. The operation unit 24 is provided outside of the sample chamber 14. Therefore, at a portion of the sample chamber 14 through which the anti-contamination plate 22 or the supporting member 23 penetrates, a vacuum seal structure for sealing the sample chamber 14 is provided.

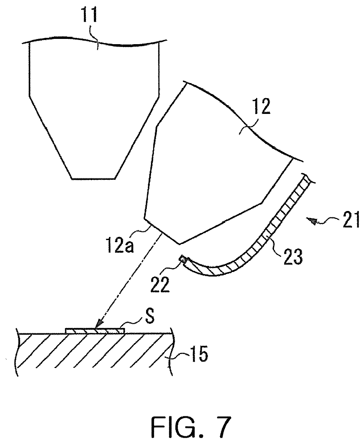

The anti-contamination plate 22 of the above-described column contamination prevention unit 21 is provided to move between an inserted position of FIG. 6 and an open position of FIG. 7. That is, the inserted position is a position where an end-side portion of the anti-contamination plate 22 is inserted into a space between the beam emission surface 12a of the electron beam column 12 and the sample tray 15. According to the embodiment of the present invention, the anti-contamination plate 22 is arranged to cover a portion right ahead of the beam emission surface 12a of the electron beam column 12 at the inserted position.

At the inserted position, the anti-contamination plate 22 is composed of an arc shape leaf spring such that it is unnecessary to support the anti-contamination plate 22 by the supporting member 23 in front of the beam emission surface 12a of the electron beam column 12. The anti-contamination plate 22 is maintained to extend in a straight line parallel to the beam emission surface 12a of the electron beam column 12 without being supported by the supporting member 23 at a position that overlaps with the beam emission surface 12a of the electron beam column 12, and without heavily drooping due to its own weight in front of the beam emission surface 12a of the electron beam column 12. That is, at the inserted position, the anti-contamination plate 22 is supported by the supporting member 23 provided at a position that does not overlap with the beam emission surface 12a of the electron beam column 12 in a cantilever manner. In addition, as shown in FIG. 4, at the inserted position, the anti-contamination plate 22 having an arc shape cross section has opposite ends that protrude more toward the electron beam column 12 in comparison with a center portion of the anti-contamination plate, and has a concave surface facing the beam emission surface.

In the meantime, the open position is a position where an end-side portion of the anti-contamination plate 22 is withdrawn from the space between the beam emission surface 12a of the electron beam column 12 and the sample tray 15. In this case, the beam emission surface 12a of the electron beam column 12 is opened (exposed), and the anti-contamination plate 22 does not cover the front of the beam emission surface 12a of the electron beam column 12.

An operation of the composite charged particle beam apparatus including the above-described column contamination prevention unit will be described.

When performing cross section processing and observation on a sample S by using the FIB-SEM apparatus 10, for example, vicinities of a position of an observation target that is present in the sample S are irradiated by using a focused ion beam of the focused ion beam column 11, thereby obtaining a cross section with etching processing.

When emitting the focused ion beam from the focused ion beam column 11, the anti-contamination plate 22 of the column contamination prevention unit 21 is positioned at the inserted position of FIG. 6. Thus, the front of the beam emission surface 12a of the electron beam column 12 is shielded by the anti-contamination plate 22.

When the sample S is irradiated by using the focused ion beam, sputtered particles M are scattered from the sample S. Lots of sputtered particles M are scattered toward the electron beam column 12 that is positioned close to the sample S. However, the front of the beam emission surface 12a of the electron beam column 12 is covered by the anti-contamination plate 22 such that the sputtered particles M do not enter the electron beam column 12 from the beam emission surface 12a thereof and, for example, do not adhere to an objective lens, etc. Therefore, it is possible to prevent the inside of the electron beam column 12 from being contaminated by the scattered sputtered particles M.

When the processing of the sample S irradiated once by using the focused ion beam is completed, a condition for cross section processing and observation is set thereafter, and cross section observation is performed by irradiating a cross section of the sample S by using an electron beam of the electron beam column 12.

When performing cross section processing and observation, the anti-contamination plate 22 of the column contamination prevention unit 21 is positioned at the open position of FIG. 7 in advance. Thus, the anti-contamination plate 22 is withdrawn from the front of the beam emission surface 12a of the electron beam column 12, and the beam emission surface 12a of the electron beam column 12 is exposed to the sample S.

When performing cross section processing and observation, cross section processing is performed by positioning the anti-contamination plate 22 at the inserted position in the previous process, and thus the inside of the electron beam column 12 is not contaminated by the sputtered particles M. In addition, there are no problems such as bending of the track of the electron beam caused by the attached sputtered particles, a change in a focus or an emitting point, etc. Consequently, a cross section of the sample S may be observed with high precision.

The operation unit 24 moving the anti-contamination plate 22 of the column contamination prevention unit 21 between the inserted position and the open position is preferably controlled by a control device controlling the entire composite charged particle beam apparatus 10 in company with operations of the focused ion beam column 11 and the electron beam column 12. That is, in an operation mode for emitting a focused ion beam from the focused ion beam column 11, the control device controls the operation unit 24 to automatically position the anti-contamination plate 22 at the inserted position. In addition, in an operation mode for emitting an electron beam from the electron beam column 12, the control device controls the operation unit 24 to automatically position the anti-contamination plate 22 at the open position. Thus, it is possible to prevent malfunction such as emitting a focused ion beam or an electron beam without changing the position of the anti-contamination plate 22.

A method of obtaining a three-dimensional image of a sample by using the FIB-SEM apparatus 10 includes: performing etching processing by irradiating a sample S with an FIB from the focused ion beam column 11 so as to expose a cross section of the sample S; performing SEM observation by irradiating the exposed cross section with an EB from the electron beam column 12 so as to obtain a cross-section image of the sample S; performing the etching processing by irradiating the sample S with the FIB again so as to expose a subsequent cross section of the sample S; and performing the SEM observation so as to obtain the second cross-section image. In this way, the etching processing and the SEM observation are repeated along an arbitrary direction of the sample, and thus multiple cross-section images of the sample S are obtained. Lastly, for example, image processing by a computer is performed on the obtained multiple cross-section images in three-dimensions, thereby obtaining a three-dimension image of the sample S.

In addition, the operation unit 24 for operating the anti-contamination plate 22 is provided outside of the sample chamber 14, whereby it is possible to prevent contamination in the sample chamber 14 that is caused by providing a mechanical operation device in the sample chamber 14, and to maintain a clean environment of the inside of the sample chamber 14.

In addition, the anti-contamination plate 22 is made of a non-magnetic material, whereby it is possible to exclude effects caused by magnetism relative to the electron beam emitted from the electron beam column 12. That is, even though the anti-contamination plate 22 is positioned at the open position, the end portion of the anti-contamination plate is positioned at a vicinity of the beam emission surface 12a of the electron beam column 12. On this account, when the anti-contamination plate 22 is made of a magnetic material, the track of the electron beam may be changed by the magnetism. However, when the anti-contamination plate 22 is made of a non-magnetic material, such a change in the track of the electron beam caused by the magnetism is prevented. When SEM resolution is enhanced by enabling a magnetic field of an objective lens for SEM to flow to vicinities of the sample and enabling the lens surface to be close to the sample, it is essential for the anti-contamination plate to be made of a non-magnetic material.

In addition to the repetition of the processing and the observation on time series as described above, the composite charged particle beam apparatus 10 also uses a mode for observing conditions of the processing in real time. For example, when a back-scattered electron detector is used, an image may be obtained by using only the back-scattered electrons, which are generated by emitting the electron beam, without capturing secondary electrons generated by emitting an FIB. Thus, the processing and the observation may be performed simultaneously. In addition, when an electric current of the electron beam is set to be extremely strong in comparison with an electric current of the FIB, secondary electrons become dominant by the electron beam, and the image has some noise, but it is possible to simultaneously perform the processing and the observation.

In those operation modes, the processing is performed without inserting the anti-contamination plate in to the front of the electron beam column 12, and thus it is desirable to manage an amount of the current of the FIB or use time. Like the present invention, it is desirable to connect each of the components to a control device controlling the entire apparatus, and to provide the components to operate with each other.

The focused ion beam column 11 may be a column including a plasma ion source and emitting a high current. The present invention is highly effective in handling the sputtered particles that are caused by processing a large area with high speed due to a high current.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A composite charged particle beam apparatus comprising:
a sample tray (15) on which a sample (S) is placed;
a focused ion beam column (11) irradiating a focused ion beam on the sample (S);
an electron beam column (12) irradiating an electron beam on the sample (S); and
a sample chamber (14) accommodating the sample tray (15), the focused ion beam column (11), and the electron beam column (12);
**characterized by** further comprising
an anti-contamination plate (22) displaceable between an inserted position inserted between a beam emission surface (12a) of the electron beam column (12) and the sample tray (15) and an open position taken out from between the beam emission surface (12a) and the sample tray (15); and
an operation unit (24) for displacing the anti-contamination plate (22) between the inserted position and the open position.

2. The apparatus of claim 1, wherein the anti-contamination plate (22) covers the beam emission surface (12a) of the electron beam column (12) and vicinities thereof at the inserted position.

3. The apparatus of claim 1 or 2, wherein the operation unit (24) is provided outside of the sample chamber (14).

4. The apparatus of any one of claims 1 to 3, wherein the anti-contamination plate (22) is made of a non-magnetic material.

5. The apparatus of any one of claims 1 to 4, wherein the anti-contamination plate (22) is made of a band-shaped 1 spring material.

6. The apparatus of claim 5, wherein the anti-contamination plate (22) is supported to be slidable along a longitudinal direction by a supporting member supporting both side surfaces of the anti-contamination plate (23) along a longitudinal direction and vicinities thereof and the supporting member (23) is placed at a position not overlapping with the beam emission surface (12a) of the electron beam column (12).

7. The apparatus of claim 5 or 6, wherein a cross section of the anti-contamination plate (22) perpendicular to a longitudinal direction forms an arc and, at the inserted position, ends of both sides of the anti-contamination plate (22) protrude towards beam emission surface of the electron beam column (12) more than a center portion of the anti-contamination plate (22).
